# FASCICULE DE BREVET EUROPEEN

(11) **EP 4 170 368 B1**
(45) Date de publication et mention de la délivrance du brevet: **24.07.2024**
(21) Numéro de dépôt: 22202338.4
(22) Date de dépôt: 18.10.2022
(51) Int. Cl.: G01R 31/367, G01R 31/392

(54) **PRÉDICTION DE L ÉTAT DE SANTÉ D'UN DISPOSITIF ÉLECTROCHIMIQUE PAR MESURE DE SA CHUTE DE CAPACITÉ**
VORHERSAGE DES GESUNDHEITSZUSTANDES EINER ELEKTROCHEMISCHEN VORRICHTUNG DURCH MESSUNG SEINES KAPAZITÄTSABFALLS
PREDICTION OF THE STATE OF HEALTH OF AN ELECTROCHEMICAL DEVICE BY MEASURING ITS CAPACITY DROP

(30) Priorité: 18.10.2021 FR 2111014
(43) Date de publication de la demande: 26.04.2023
(73) Titulaire: Electricité de France, 75008 Paris (FR)
(72) Inventeur: Fuhrmann, Marion, 75014 PARIS (FR); Kobayashi, Yo, 77300 FONTAINEBLEAU (FR)
(74) Mandataire: Plasseraud IP

(56) Documents cités:
- EP-A1- 3 196 663
- WO-A1-2020/033343
- YANG SIJIA ET AL: "Review on state-of-health of lithium-ion batteries: Characterizations, estimations and applications", JOURNAL OF CLEANER PRODUCTION, ELSEVIER, AMSTERDAM, NL, vol. 314, 20 June 2021 (2021-06-20), XP086721137, ISSN: 0959-6526, [retrieved on 20210620], DOI: 10.1016/J.JCLEPRO.2021.128015
- OUYANG MINGGAO ET AL: "A dynamic capacity degradation model and its applications considering varying load for a large format Li-ion battery", APPLIED ENERGY, ELSEVIER SCIENCE PUBLISHERS, GB, vol. 165, 30 December 2015 (2015-12-30), pages 48 - 59, XP029400190, ISSN: 0306-2619, DOI: 10.1016/J.APENERGY.2015.12.063

## Description

### Domaine technique

L'invention se situe dans le domaine du stockage d'énergie et de l'estimation de la durée de vie des dispositifs de stockage d'énergie.

### Technique antérieure

L'invention est relative à tout type de dispositif et/ou système de stockage d'énergie électrochimique, tels que :
- Batterie rechargeable,
- Batterie lithium-ion,
- Batterie à l'état solide lithium-ion,
- Batterie sodium-ion,
- Batterie à l'état solide sodium-ion, et/ou autres.

Ces équipements peuvent être prévus pour des smartphones, des ordinateurs portables, ou encore pour des véhicules électriques (EV), ou encore pour des systèmes (BES) de production d'énergie électrique à partir d'énergie solaire ou éolienne, ou autres.

Le document "YANG SIJIA ET AL: "Review on state-of-health of lithium-ion batteries: Characterizations, estimations and applications",JOURNAL OF CLEANER PRODUCTION, ELSEVIER, AMSTERDAM, NL, vol. 314, 20 juin 2021 (2021-06-20), ISSN: 0959-6526, DOI:10.1016/J.JCLEPRO.2021.128015" divulgue généralement l'utilisation de la dérivée de la fonction température/état de charge pour identifier et ajuster mathématiquement les pics associés aux contributions des électrodes positives et négatives d'une batterie à la dégradation de la capacité de la batterie.

Par conséquent, l'invention peut être appliquée à tous les dispositifs et systèmes dans lesquels il existe des dispositifs électrochimiques de stockage d'énergie électrique.

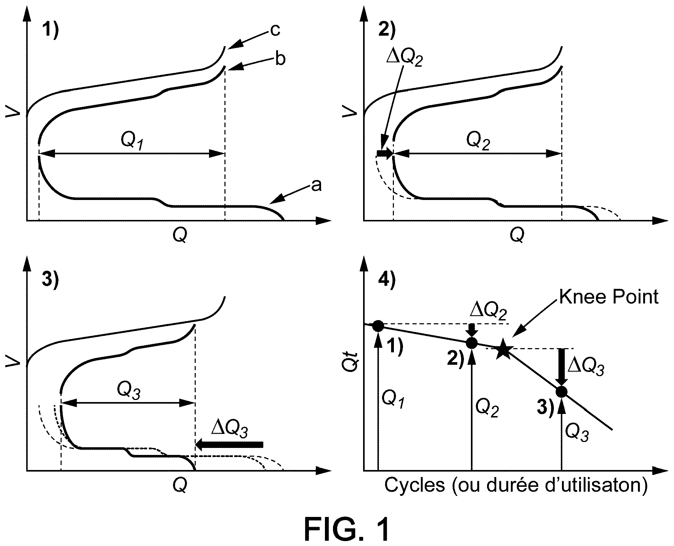

Dans de tels dispositifs et/ou systèmes, il est cherché à prédire une « chute rapide » de la capacité (nommée ci-après « Knee Point » en anglais) des dispositifs de stockage d'énergie électrochimique à l'aide notamment de la mesure et du suivi de la tension. En référence à la figure 1 (partie 4) en bas à droite), le knee point désigne plus précisément une accélération de la chute de capacité : typiquement, il peut s'agir, comme illustré dans l'exemple représenté, d'un changement de pente dans la décroissance de la capacité en fonction du nombre de cycles d'utilisation (ou d'une durée d'utilisation plus généralement). Cette capacité est notée Qt sur les figures et représente la capacité totale (i.e. maximum) du dispositif électrochimique. Elle correspond généralement à la capacité de la cathode qui est limitante lorsque le dispositif est neuf. On voit en particulier sur la figure 1-4) que la pente augmente en valeur absolue à un cycle donné, correspondant au « Knee Point » précité.

À ce jour, cette chute de capacité est observée en particulier dans les batteries au lithium, et est souvent liée à un dépôt métallique de lithium (ou « Li plating »), mais une telle chute de capacité peut se produire plus généralement dans les batteries utilisant des matériaux d'intercalation pour ses deux électrodes (anode et cathode).

Les dispositifs de stockage électrochimique de type Li-ion rechargeables sont basés sur des réactions réversibles à l'électrode positive (cathode) et négative (anode). La réaction dite « d'intercalation » est au centre du développement des batteries Li-ion car elle présente une réversibilité élevée pendant les opérations de charge / décharge.

Pendant la réaction « d'intercalation », les ions cibles (par exemple lithium ou éventuellement sodium) se déplacent entre la cathode et l'anode à l'état d'ion, et non à l'état métallique pendant tout le fonctionnement du dispositif. Par exemple, dans le cas d'une batterie lithium-ion en charge, les ions Li sont libérés de la cathode (réaction de désintercalation ou désinsertion) et s'insèrent à l'anode (réaction d'intercalation ou d'insertion). Lors de la décharge, la réaction opposée se produit à la cathode (intercalation) et à l'anode (désintercalation). Une telle réaction à l'état « ionique » permet d'assurer sa réversibilité et le bon fonctionnement du dispositif électrochimique rechargeable.

Une telle réaction est réversible tant qu'aucun dépôt métallique ne se produit. En d'autres termes, si la réaction de dépôt à l'état "métal" se produit (« Li plating »), elle induit une réaction irréversible. En plus de dégrader les performances du dispositif et de réduire considérablement sa capacité, le « Li plating » favorise la formation de dendrites de Lithium qui peuvent créer des courtscircuits internes et donc des problèmes de sécurité. C'est pourquoi il est important de limiter au maximum tout dépôt de métal lors du fonctionnement des dispositifs de stockage électrochimique rechargeables.

Le dépôt localisé de lithium métallique peut se produire principalement sur les anodes en graphite en raison de la proximité du potentiel du graphite et celui du lithium métallique.

La capacité d'intercalation de l'électrode est définie à partir du nombre de sites cristallographiques accessibles aux espèces ioniques, ou à partir du rapport entre les espèces ioniques et le métal hôte dans le cas d'un alliage métallique. La quantité maximale d'ions acceptés par chaque électrode correspond donc à sa capacité théorique. Lorsqu' un excès d'ions migre vers l'anode (c'est-à-dire plus d'ions que de sites disponibles), ces ions ne s'insèrent plus dans la structure mais se déposent en surface du graphite sous forme de métal. Par conséquent, les dispositifs de stockage électrochimique rechargeables sont souvent conçus avec une capacité excédentaire côté anode.

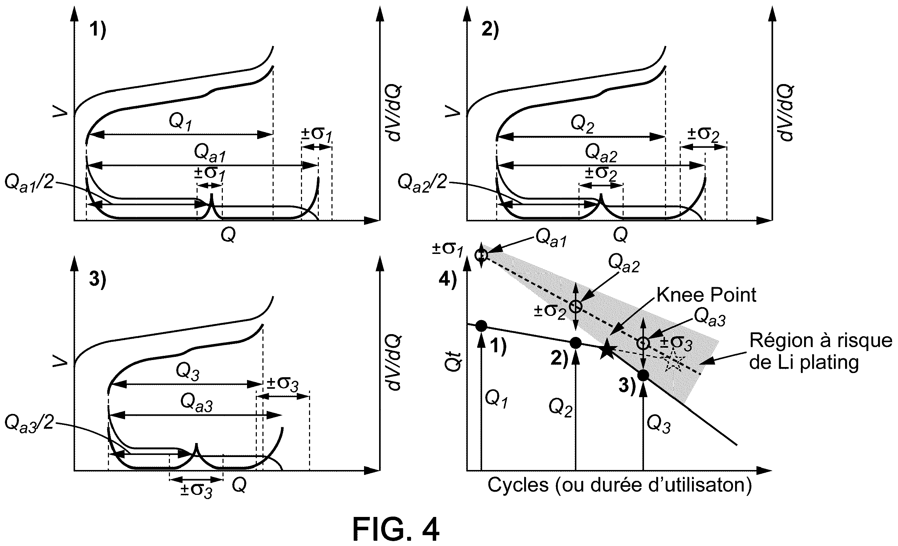

Lorsque des dépôts de métal se produisent au cours du fonctionnement du dispositif, d'importantes réactions irréversibles se produisent et entrainent une diminution rapide de la capacité. On observe alors un point d'inflexion sur la courbe de vieillissement du dispositif correspondant au "Knee Point" précité, représenté par une étoile sur la figure 4. La zone à risque de placage métallique (au Lithium par exemple) est illustrée en grisé dans la figure 4 (partie 4 en bas à droite). Plus généralement, un "Knee Point" peut également être observé avec d'autres mécanismes de dégradation, tels que la perte de capacité de la cathode, la perte d'électrolyte liquide, ou autres (par exemple dans des dispositifs autres que des batteries lithium-ion). Cependant, le "Knee Point" induit par le dépôt de lithium métallique conduit également à un état dangereux du dispositif (risque d'incendie notamment). Par conséquent, le "Knee Point" dû au placage métallique est l'événement le plus important à éviter en fonctionnement.

Il est expliqué ci-après un exemple d'apparition d'un Knee Point suite au dépôt de lithium métallique.

Le profil de tension V d'un dispositif de stockage électrochimique rechargeable, en fonction de son état de charge (noté Q sur les figures), est déterminé par la différence de potentiel entre la cathode et l'anode. Il constitue un bon indicateur permettant de prévoir le "Knee Point" lié à un dépôt de lithium métal. Un exemple typique d'analyse est présenté sur la figure 1- 1). La courbe référencée « a » représente le profil de tension de l'anode et la courbe « c » le profil de tension de la cathode, pendant la charge. La courbe « b » représente la tension du dispositif, qui correspond à la courbe « c » - « a ». La capacité réversible du dispositif correspond alors à la région de chevauchement, référencée Q1. On suppose dans cet exemple qu'il n'y a pas de perte de capacité du côté de la cathode.

Après dégradation/vieillissement, la capacité réversible du dispositif est réduite à Q2 dans la figure 1- 2). Dans ce cas, la tension de l'anode est décalée vers la droite (déplacement de la courbe) de ΔQ2 et réduite (avec un rétrécissement de la courbe). Ici, la capacité réversible de l'anode a diminué mais elle reste supérieure à la capacité du dispositif (limitée par la capacité de la cathode), de sorte qu'il n'y a pas (encore) d'effet sur la capacité totale du dispositif.

Après un vieillissement supplémentaire, la capacité réversible est réduite à Q3 comme illustré sur la figure 1- 3). Dans ce cas, la capacité réversible de l'anode (qui devient l'électrode limitante et détermine maintenant la capacité totale du dispositif) devient inférieure à la capacité de la cathode. Il y a donc un excès d'ions lithium par rapport aux sites d'insertion disponibles à l'anode et le potentiel anodique atteint 0 V, induisant un risque non négligeable de dépôt métallique.

La figure 1- 4) montre une tendance typique de la capacité Qt en fonction des cycles de charge/décharge (ou de la durée de fonctionnement) d'un dispositif électrochimique du type précité. Entre Q1 et Q2, la pente de la perte de capacité est constante car elle est régie par la valeur prise par ΔQ2. Ensuite, la pente de la perte de capacité change formant un point d'inflexion : il s'agit du "Knee Point". Ainsi dans cas, la perte de capacité est maintenant régie par la perte de capacité de l'anode. Il s'agit d'un exemple typique pour illustrer l'apparition du "Knee Point" due à une dégradation de l'anode.

Comme l'anode est en général dimensionnée de manière à ce que sa capacité soit supérieure à celle de la cathode afin d'éviter le placage métallique, il est difficile, voire impossible en pratique, de mesurer directement la capacité de l'anode directement à partir de la variation de tension du dispositif.

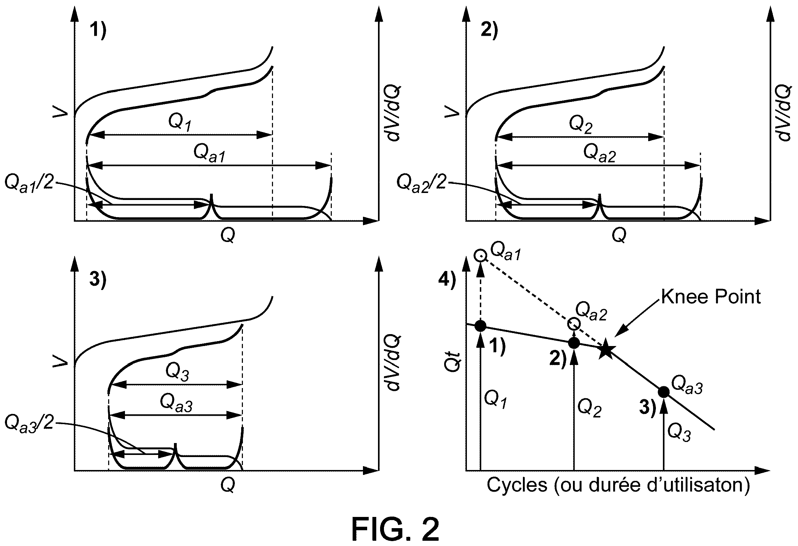

Pour estimer la capacité de l'anode, une analyse de la dérivée (analyse différentielle) de la tension par rapport à la capacité (dV/dQ) est généralement utilisée. En référence à la figure 2, il s'agit de la variation dV/dQ (à droite de chaque graphe 1) à 3)) marquée en traits forts noirs. Par exemple, le matériau anodique (du graphite typiquement) présente un profil de tension constitué de plateaux pendant l'intercalation et la désintercalation des ions lithium. Le plateau le plus distinct est observé à la moitié de la capacité de l'anode, Qa/2, comme illustré sur la figure 2. Le début de la charge est supposé commencer avec l'anode complètement dé-lithiée (lorsque presque aucun ion lithium n'est présent dans la structure du graphite). Par conséquent, la capacité mesurée entre le début de la charge et le pic le plus élevé de dV/dQ se situe à Qa/2. La capacité réversible de l'anode Qa peut alors être estimée à partir de la position de ce pic par Qa = 2 x Qa/2, comme le montre la figure 2- 1).

Après dégradation comme dans la figure 2- 2), la perte de capacité de l'anode peut être estimée en utilisant l'analyse dV/dQ. Il est alors possible de prévoir l'apparition d'un Knee Point en utilisant l'analyse de dV/dQ et l'estimation de la capacité de l'anode après dégradation. En traçant la capacité réversible de l'anode en fonction des cycles de charge/décharge ou des jours d'utilisation, il est possible de prévoir le Knee Point en extrapolant la tendance de la capacité de Qa et en trouvant son point d'intersection avec la capacité du dispositif. En d'autres termes, le Knee Point correspond au point pour lequel la capacité totale du dispositif Qt devient égale à la capacité de l'anode Qa (l'électrode limitante n'étant plus la cathode mais devenant l'anode).

Cette estimation de l'apparition d'un Knee Point se base sur la capacité entre deux pics pour obtenir la valeur de la mi-capacité d'anode Qa/2. Cependant, l'expérience montre en pratique qu'il peut arriver qu'un Knee Point apparaisse avant sa prévision par cette technique. En d'autres termes, le Knee Point peut apparaître lorsque la capacité réversible de l'anode Qa est encore supérieure à la capacité Qt du dispositif. Par conséquent, des considérations supplémentaires doivent être mises en oeuvre pour prévoir le Knee Point plus finement, pour une utilisation pratique.

### Résumé

La présente invention vient améliorer la situation.

Elle propose à cet effet un procédé de prédiction d'une accélération de dégradation de la capacité d'un dispositif électrochimique (constatée par observation d'une rupture de pente ou point d'inflexion du type « Knee Point » précité, dans l'évolution de la capacité), le procédé comportant :
- Une obtention de données de mesure de points d'une fonction liant une tension (V) aux bornes du dispositif électrochimique à un état de charge (Q) du dispositif électrochimique, et d'une mesure de capacité (totale) du dispositif électrochimique,
- Un calcul de la dérivée de ladite fonction et une identification d'un pic de variation de ladite dérivée, dû à une inflexion de variation de ladite fonction et caractérisant une grandeur représentative d'une capacité d'anode du dispositif électrochimique (Qa/2),
- Une estimation d'une largeur du pic (σ) et une comparaison d'une combinaison de la largeur de pic et de la grandeur représentative de la capacité d'anode, à la mesure de capacité (Qt) du dispositif électrochimique, et
- Si ladite combinaison est inférieure à la capacité du dispositif électrochimique, une prédiction d'accélération de la dégradation de la capacité du dispositif électrochimique.

Ainsi, l'invention propose de prédire le "Knee Point" précité en se basant sur la position et le degré d'élargissement des pics de la courbe d'une fonction dérivée telle que dV/dQ, élargissement qui est représentatif du degré d'inhomogénéité au sein du dispositif électrochimique. En analysant ce degré d'inhomogénéité, il est possible de prédire l'apparition du "Knee Point" (et ce pour diverses applications).

Dans un mode de réalisation, la fonction dont la dérivée est calculée (dV/dQ) est la variation de la tension (V) en fonction de l'état de charge (Q) du dispositif électrochimique, et la grandeur représentative de la capacité d'anode est la moitié de la capacité de l'anode du dispositif électrochimique (Qa/2), donnée par l'abscisse du pic précité.

Bien entendu, alternativement, il est possible de retrouver également un point de singularité donné par la dérivée dQ/dV de la fonction réciproque Q(V) (au lieu du choix de la fonction V(Q) ci-dessus).

Dans une réalisation, l'estimation de la largeur du pic (σ) est effectuée par ajustement (ou « fit » en anglais) du pic par une gaussienne et en mesurant ainsi la largeur de cette gaussienne.

La largeur σ de la gaussienne peut être typiquement donnée par la base de la gaussienne (intersection avec l'axe des abscisses) ou estimée à partir de sa largeur à mi-hauteur par exemple, ou autre.

Bien entendu, l'ajustement par une gaussienne en particulier peut trouver des variantes (ajustement par courbe de Bézier, ou autres).

Dans une réalisation, la combinaison précitée est donnée par 2*(Qa/2) - N. σ - ε, où :
- (Qa/2) est une valeur correspondant à la moitié de la capacité de l'anode du dispositif électrochimique,
- N est un entier naturel supérieur ou égal à 1,
- σ correspond à l'estimation de la largeur du pic, et
- ε est un seuil de sécurité, choisi (par exemple égal à un pourcentage de la capacité totale Qt du dispositif électrochimique, par exemple 10% de Qt).

L'entier N peut être choisi par exemple en fonction du type de dispositif électrochimique en jeu (par exemple N=3).

Dans une réalisation, si la combinaison précitée est inférieure à la capacité du dispositif électrochimique, une dégradation physique, accélérée, du dispositif électrochimique, caractérisée par la formation d'un dépôt métallique à l'anode du dispositif électrochimique, est en outre prédite.

Par exemple, le dispositif électrochimique peut comporter au moins une batterie au lithium et le dépôt se formant à l'anode est un dépôt de lithium métallique.

Dans le cas d'une batterie sodium-ion, il peut se former également un dépôt de sodium à l'anode.

Cette accélération de la dégradation de la capacité peut intervenir de manière plus générale dans les dispositifs à anode comportant du graphite (pur ou en alliage).

Une telle situation est signe d'une mort imminente du dispositif électrochimique.

Une telle extrémité peut être atteinte notamment quand la capacité totale Qt devient égale à 2*(Qa/2) - N. σ. On comprendra ainsi que le terme ε ci-dessus sert à avertir un utilisateur suffisamment tôt.

D'ailleurs, dans une réalisation, le procédé comporte en outre la génération d'un signal d'alerte si la combinaison précitée est inférieure à la capacité du dispositif électrochimique, et en particulier si la marge que représente le seuil de sécurité ε commence à être atteinte.

En particulier, le signal d'alerte (ou un deuxième signal d'alerte) peut indiquer une fin de vie imminente du dispositif électrochimique (en particulier si la marge ε a été dépassée).

Dans une réalisation, la prédiction précitée d'accélération de la dégradation de la capacité du dispositif électrochimique peut être corroborée par une augmentation, au-delà d'un seuil (qui peut être prédéfini ou relatif), d'un volume mesuré du dispositif électrochimique (comme présenté plus loin dans des exemples de réalisation).

La présente invention vise aussi un dispositif de prédiction d'une accélération de dégradation de la capacité d'un dispositif électrochimique, comportant au moins un circuit de traitement relié au dispositif électrochimique pour la mise en oeuvre du procédé présenté ci-avant.

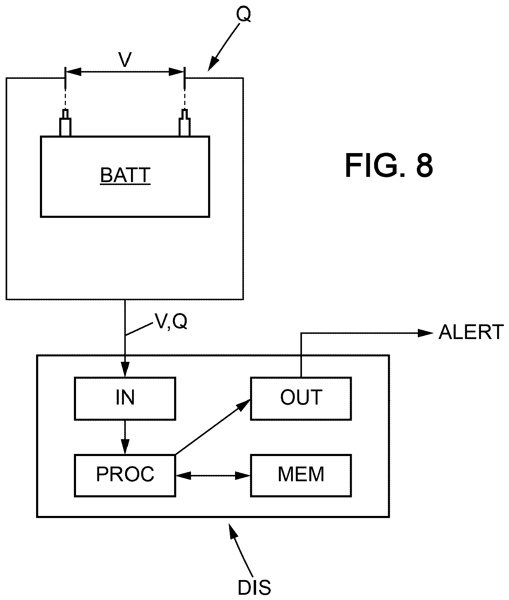

En référence à la figure 8, le circuit de traitement du dispositif de prédiction DIS peut comporter :
- une interface d'entrée IN de signaux issus du dispositif électrochimique BATT, pendant sa charge ou sa décharge, ces signaux étant alors la tension V (en volts) appliquée aux bornes du dispositif électrochimique BATT et la charge/décharge Q (en ampères-heures),
- une mémoire MEM apte à stocker au moins temporairement des valeurs de tension et de charge / décharge, ainsi que des données d'instructions d'un programme informatique pour la mise en oeuvre du procédé ci-avant,
- un processeur PROC capable de coopérer avec la mémoire MEM et en particulier de lire les instructions stockées dans la mémoire pour exécuter notamment les étapes de calcul et de comparaison du procédé défini ci-avant, et
- une interface de sortie OUT coopérant avec le processeur PROC pour délivrer éventuellement un signal d'alerte ALERT destiné à être joué par une interface homme/machine (affichage sur un écran ou diffusion d'un signal audio).

Le circuit de traitement peut comporter en outre un coupe-circuit (non représenté sur la figure 8) pour isoler le dispositif électrochimique et arrêter son fonctionnement (en charge ou décharge) lorsque la capacité totale Qt devient égale à 2*(Qa/2) - N. σ (donc lorsque la marge ε est dépassée par exemple).

La présente invention vise aussi le programme informatique comportant des instructions pour la mise en oeuvre du procédé ci-avant, lorsque ces instructions sont exécutées par un processeur d'un circuit de traitement (par exemple du type illustré sur la figure 8).

Selon un autre aspect, il est proposé un support d'enregistrement non transitoire, lisible par un ordinateur, sur lequel est enregistré un tel programme.

### Brève description des dessins

D'autres caractéristiques, détails et avantages apparaîtront à la lecture de la description détaillée ci-après, et à l'analyse des dessins annexés, sur lesquels :
**Fig. 1**
   [Fig. 1] illustre le principe de l'apparition du "Knee Point", dérivé par exemple de la chute de la capacité anodique entrainant un changement de pente de la capacité du dispositif.
**Fig. 2**
   [Fig. 2] illustre la prévision du Knee Point" par analyse de la dérivée dV/dQ.
**Fig. 3**

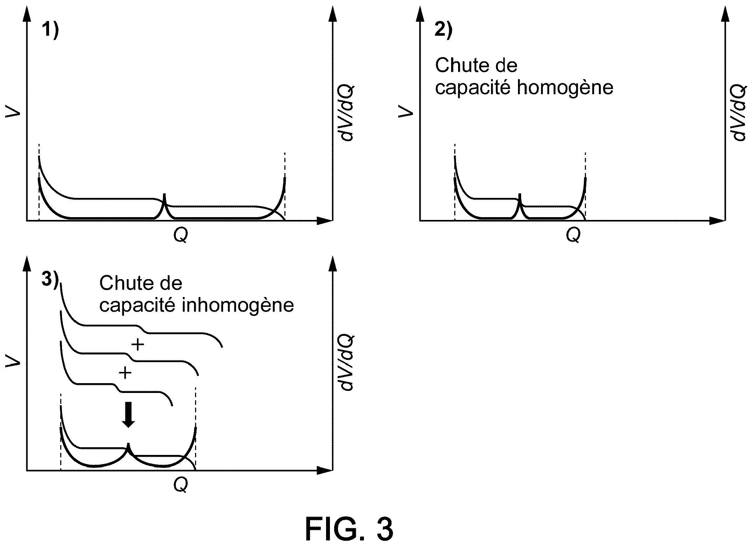

   [Fig. 3] illustre une perte de capacité inhomogène entrainant un Knee Point précoce.
**Fig. 4**
   [Fig. 4] illustre la prévision du Knee Point, par analyse de la dérivée dV/dQ et utilisant une distribution gaussienne σ (σ1, σ2, σ3), cette distribution caractérisant (et croissant avec) la dégradation du dispositif électrochimique.
**Fig. 5**

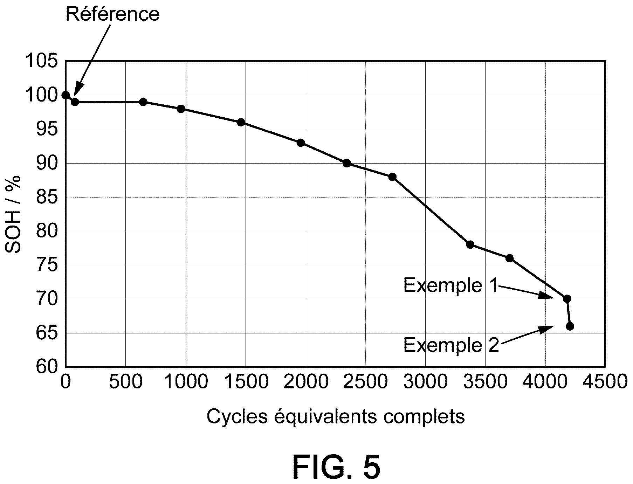

   [Fig. 5] illustre la dégradation de l'état de santé du dispositif (ou SoH pour « State of Health »), par la perte accélérée de la capacité, en fonction du nombre de cycles, avec ici deux états de dégradation (« exemple 1 » correspondant au point avant le knee point et « exemple 2 » correspondant au point après le knee point) apparaissant après 4000 cycles, et ce en partant d'un état de référence dont le SoH est fixé à 100%.
**Fig. 6**

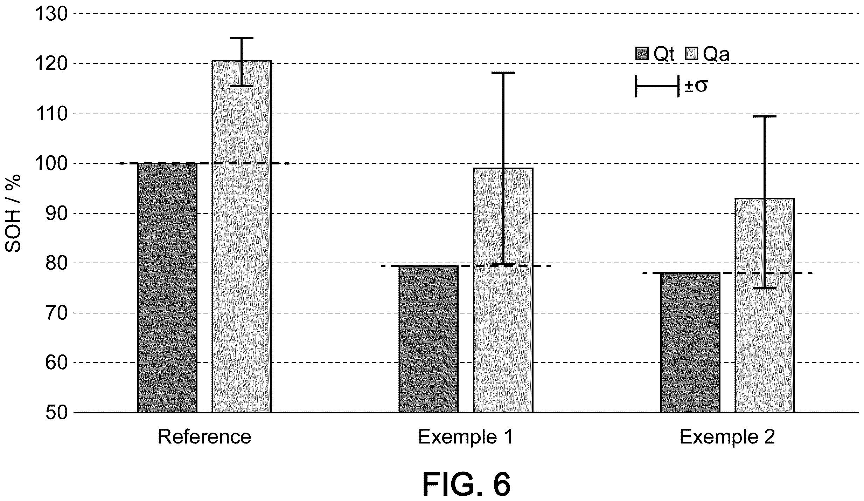

   [Fig. 6] illustre la capacité totale du dispositif électrochimique (Qt) et la capacité de l'anode (Qa) avant et après vieillissement, et les barres verticales correspondent à la distribution σ de la capacité estimée par ajustement gaussien des courbes dV/dQ au point Qa/2.
**Fig. 7**

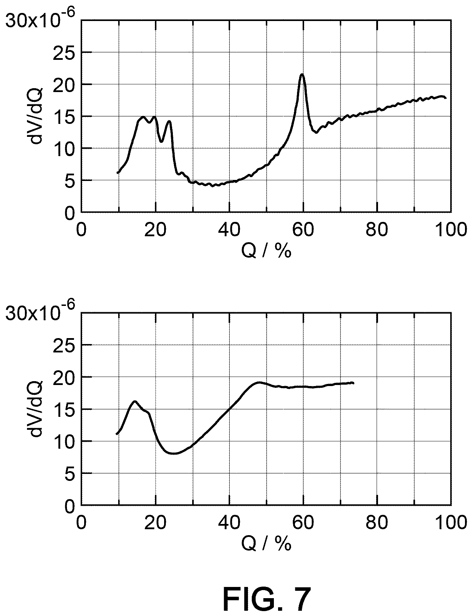

   [Fig. 7] montre comparativement le pic de dV/dQ pour un état proche d'un état de référence (haut de la figure), avec un élargissement de ce pic (autour de 50%) pour un état plus dégradé du même dispositif électrochimique (bas de la figure 7), donnant ainsi la largeur σ de la distribution.
**Fig. 8**
   [Fig. 8] présente schématiquement un exemple de dispositif de prédiction, comme décrit précédemment.

### Description des modes de réalisation

On se réfère tout d'abord à la figure 3 pour expliquer le degré d'inhomogénéité du dispositif, la figure 3 proposant de se concentrer sur la tension anodique et les courbes dV/dQ avant et après la chute de la capacité.

Dans le cas d'une perte homogène de la capacité, l'anode se dégrade de manière homogène sur toute sa surface. Dans ce cas, le profil de tension des électrodes est identique en tout point du dispositif. Par conséquent, il n'y a pas d'élargissement de la courbe dV/dQ après vieillissement du dispositif, comme le montre la figure 3- 2).

En revanche, si la perte de capacité de l'anode est hétérogène (dégradation plus ou moins importante selon les zones), la tension de l'électrode est différente d'une position à l'autre. Certaines zones conservent encore une capacité élevée tandis que d'autres zones perdent davantage de capacité. Cette situation est illustrée sur la figure 3- 3. Il y a rupture de pente dans les deux cas mais si la dégradation est inhomogène, il est préférable de prendre en compte la variabilité de la tension de l'anode pour prédire l'arrivée d'un Knee Point avec une bonne fiabilité. Ce type de dégradation inhomogène se produit surtout pour des dispositifs de grande capacité en raison de surfaces de réaction importantes et/ou en raison de la forte variation des conditions thermiques au sein du dispositif électrochimique, mais cela peut se produire également pour des dispositifs de petite taille. Les courbes dV/dQ correspondantes montrent un élargissement des pics (figure 7) en raison de la variation importante de la tension de l'anode sur toute sa surface.

L'invention propose alors de prédire l'apparition du Knee Point en utilisant le degré d'inhomogénéité présent au sein du dispositif, comme le montre la figure 4. Le degré d'inhomogénéité peut être estimé en ajustant le pic correspondant à la moitié de la capacité de l'anode, Qa/2. Le pic peut être extrapolé par une courbe gaussienne.

La figure 4- 4) montre une mise en oeuvre de cette réalisation pour la prévision du risque de Knee Point lié par exemple au dépôt de métal à l'anode. Dans l'état de l'art existant, le Knee Point est estimé simplement par la valeur de Qa/2 (position du pic correspondant sur la courbe dV/dQ) représentée par l'étoile grise en pointillés de la figure 4-4). Dans l'invention, le risque de dépôt de métal peut être détecté en utilisant la distribution du pic gaussien (position et largeur du pic correspondant sur la courbe dV/dQ), représenté par la zone grise en forme de cône sur la figure 4-4). Le risque de Knee Point ainsi estimé correspond au point d'intersection de l'extrapolation de la ligne Q1-Q2 avec la zone grise, marqué par l'étoile noire de la figure 4-4). On comprend ainsi que la prédiction du Knee Point au sens de l'invention (marquée par l'étoile noire) peut être plus précoce que celle de l'art antérieur (marquée par l'étoile grise).

Dans un exemple de réalisation concret, un ensemble de batteries lithium-ion de classe 200 Wh a été utilisé comme échantillon. La cathode est constituée d'un oxyde lamellaire et l'anode de graphite. Les essais de cyclage ont été réalisés à 10°C et 1C (C étant le courant appliqué en fonction de la capacité nominale de la batterie). La capacité de la batterie a été mesurée à 25°C, C/2 et C/25 avant et après cyclage. La courbe de capacité à C/2 en fonction du nombre de cycles équivalents complets est représentée sur la figure 5. Les courbes *dV*/*dQ* (à 25°C et C/25) ont également étaient calculées et ajustées à l'aide de courbes gaussiennes avant (exemple de référence) et après cyclage, plus précisément juste avant le Knee Point (premier exemple de travail), et juste après le Knee Point (deuxième exemple de travail). La marge de capacité anodique (excès de capacité à l'anode par rapport à la capacité de la cathode) avant un risque de dépôt de lithium métallique a été estimée en utilisant la distribution σ de l'ajustement gaussien.

Une première batterie a été démontée avant cyclage et une seconde après cyclage, en boîte à gants sous Argon.

Dans l'exemple de référence, la capacité initiale de la batterie avant cyclage a été définie avec un état de santé SoH de 100%. La capacité anodique estimée à partir de la valeur Qa/2 était de 120,6 % par rapport à la capacité de la batterie mesurée à C/25. La distribution de la capacité de l'anode estimée à partir de l'ajustement gaussien était de 4,8 %. Par suite, la marge de capacité anodique par rapport au risque de dépôt de lithium a été estimée à 15,8 %. Par conséquent, la marge de capacité anodique est suffisante, et le risque de dépôt de Li métal et donc de dégradation accélérée du dispositif est très limité.

D'ailleurs, dans le cas de l'échantillon de référence, il n'a pas été identifié de dépôt métallique à la surface de l'anode lors du démontage de la batterie.

Dans le premier exemple de travail, après 4182 cycles équivalents complets, le SoH mesuré à C/2 était de 69,6 % et le SoH mesuré à C/25 était de 79,4 %. La capacité anodique estimée à partir de la valeur Qa/2 était de 99,0 % par rapport à la capacité de la batterie à C/25 avant cyclage. La distribution de la capacité de l'anode estimée à partir de l'ajustement gaussien était de 19,2 %. Par suite, la marge de capacité par rapport au risque de dépôt de lithium métal a été estimée à 0,4 %.

A partir de cette faible marge, il est déjà possible de prédire qu'une accélération de la dégradation et l'observation d'un Knee Point sont probablement sur le point de se produire en raison du risque élevé de dépôt de lithium métallique. Le Knee Point peut donc être prédit avant-même l'accélération effective de la perte de capacité de la batterie.

Cette dégradation de la batterie dû au phénomène de dépôt de lithium métallique s'accompagne généralement d'un changement de volume de la batterie. Ici typiquement, l'épaisseur moyenne de la batterie était de 122,9 % par rapport à celle de la batterie de référence (augmentation de volume d'environ 23%).

Dans le deuxième exemple de travail, après 4206 cycles équivalents complets, le SoH mesuré à C/2 était de 65,9 % et le SoH mesuré à C/25 était de 78,0 %. La capacité de l'anode estimée à partir de la valeur Qa/2 était de 92,8 % par rapport à la capacité de la batterie mesuré à C/25 avant cyclage. La distribution de la capacité estimée à partir de l'ajustement gaussien était de 16,6 %. Par suite, la marge de capacité par rapport au risque de dépôt de lithium a été estimée à -1,8 %, montrant qu'il y a un fort risque que le dépôt de Li métal se soit déjà produit.

L'épaisseur moyenne de la batterie était de 134,6 % par rapport à celle de la batterie de référence (augmentation de volume de 35% environ).

Lors du démontage de cette cellule, un dépôt sous forme de poudre a été observé à la surface de l'anode. La poudre déposée a été identifiée comme étant du lithium métal par réaction avec de l'éthanol, confirmant que le mécanisme de Li plating a déjà eu lieu.

Ces résultats montrent qu'il est possible de prédire le dépôt de lithium métallique et donc un Knee Point avant son apparition effective, typiquement ici dans le premier exemple de travail.

Grâce à l'invention, la variation de la capacité anodique est prise en compte en analysant la distribution de la courbe dV/dQ au point Qa/2. La largeur du pic correspondant (par exemple à mi-hauteur) est représenté sur la figure 6 par des barres d'erreur caractérisant la variabilité de la capacité anodique au sein du dispositif pour l'exemple de référence (à SoH=100%) et les exemples 1 et 2. Dans le cas de l'exemple 1, la limite inférieure de la barre d'erreur est proche de la capacité de la batterie. Ceci indique un risque élevé de dépôt de lithium métallique à venir. Dans le cas du deuxième exemple de travail, la limite inférieure de la barre d'erreur devient inférieure à la capacité de la batterie et montre que le risque d'avoir enclenché le mécanisme de dépôt de lithium métal (et d'avoir dépassé le Knee Point) est très élevé. Le dépôt de lithium observé lors de l'ouverture de la cellule confirme que ce mécanisme a bien eu lieu. Par conséquent, l'analyse au sens de l'invention est appropriée pour identifier un dépôt de lithium dans un cas réel mais surtout pour prévoir le degré de risque de dépôt de lithium (et donc d'accélération de la perte de capacité) en analysant la distribution de la capacité de l'anode à un état de santé donné, conformément à l'exemple 1 décrit ci-avant.

Bien entendu, l'invention ne se limite pas aux formes de réalisation présentées ci-avant à titre d'exemple.

Par exemple, elle ne se limite pas à une observation de la variation de dV/dQ. Le flux thermique produit par la batterie pendant la charge et la décharge (P), peut être également utilisé comme indicateur du degré d'inhomogénéité au sein du dispositif. Dans le cas de l'analyse de P, une méthode similaire peut être appliquée, basée sur *dP*/*dQ* au lieu de *dV*/*dQ.* Il est possible également d'appliquer une analyse différentielle inverse, telle que *dOldV* et *dQ*/*dP.* On peut également utiliser la combinaison de la tension et du flux thermique, *dV*/*dP* et aussi *dPldV* pour une analyse similaire.

L'invention peut également être mise en oeuvre en appliquant la procédure proposée ci-dessus au changement d'épaisseur de la batterie. On peut par exemple obtenir un indicateur approprié en combinant l'évolution de la distribution de la capacité anodique et l'évolution de l'épaisseur de la batterie. En incluant le suivi de l'épaisseur, la précision de la prédiction du risque de Knee Point peut alors être améliorée.

Par ailleurs, l'exemple expérimental ci-avant utilise une batterie Lithium-ion. Cependant, l'invention proposée n'est pas limitée à ce type de batterie. Par exemple, dans le cas d'une batterie sodium-ion, une anode en graphite similaire est utilisée. Par conséquent, on peut également appliquer la même procédure à une batterie sodium-ion.

L'invention proposée peut également être appliquée aux batteries avec une anode de type alliage comme le silicium et/ou l'étain. Dans le cas d'une anode de type alliage, il n'y a pas de pic dV/dQ distinct lors de la charge ou de la décharge de la batterie, il est donc préférable d'utiliser la courbe dQ/dV pour estimer la distribution de capacité de la batterie.

Les résultats obtenus montrent que l'analyse au sens de l'invention est efficace pour estimer le risque de Knee Point et, de là, la durée de vie du dispositif électrochimique.

En effet, cette prévision du Knee Point au sens de l'invention peut être appliquée à l'évaluation de la durée de vie utile des dispositifs électrochimiques. Dans l'état de l'art existant, l'extrapolation de la courbe de capacité réelle (en fonction du nombre de cycles ou de jours depuis la mise en service) par une fonction linéaire ou une autre fonction mathématique est souvent utilisée pour estimer la durée de vie restante d'un dispositif. Cette méthode d'extrapolation ne permet pas d'estimer une accélération de la perte de capacité à partir du Knee Point. En estimant le degré de risque de l'apparition d'un Knee Point, il est alors possible d'estimer la durée de vie résiduelle réelle des dispositifs électrochimiques.

Ainsi par exemple, grâce à l'invention, il est possible de fournir une estimation plus précise de l'état de santé et une prédiction de la durée de vie d'une batterie à des utilisateurs de véhicules électriques. L'invention peut également permettre de déterminer avec plus de précision la valeur de revente d'une batterie de véhicule électrique en vue de sa seconde vie au sein d'un système de stockage stationnaire par exemple. Elle permet aussi à l'exploitant d'être alerté (notamment avant un risque d'accident) lorsqu'une maintenance ou un remplacement est nécessaire.

## Revendications

1. Procédé de prédiction d'une accélération de dégradation de la capacité d'un dispositif électrochimique, le procédé comportant :
- Une obtention de données de mesure de points d'une fonction liant une tension (V) aux bornes du dispositif électrochimique à un état de charge du dispositif électrochimique (Q), et d'une mesure de capacité (Qt) du dispositif électrochimique,
- Un calcul de la dérivée de ladite fonction et une identification d'un pic de variation de ladite dérivée, dû à une inflexion de variation de ladite fonction et caractérisant une grandeur représentative d'une capacité d'anode du dispositif électrochimique (Qa/2),
- Une estimation d'une largeur du pic (σ) et une comparaison d'une combinaison de la largeur de pic et de la grandeur représentative de la capacité d'anode, à la mesure de capacité (Qt) du dispositif électrochimique, et
- Si ladite combinaison est inférieure à la capacité du dispositif électrochimique, une prédiction d'accélération de la dégradation de la capacité du dispositif électrochimique.

2. Procédé selon la revendication 1, dans lequel la fonction dont la dérivée est calculée (dV/dQ) est la variation de la tension (V) en fonction de l'état de charge (Q) du dispositif électrochimique, et la grandeur représentative de la capacité d'anode est la moitié de la capacité de l'anode du dispositif électrochimique (Qa/2), donnée par l'abscisse dudit pic.

3. Procédé selon l'une des revendications précédentes, dans lequel l'estimation de la largeur du pic (σ) est effectuée par ajustement dudit pic par une gaussienne et en mesurant la largeur de ladite gaussienne.

4. Procédé selon l'une des revendications précédentes, dans lequel ladite combinaison est donnée par 2*(Qa/2) - N. σ - ε, où :
- (Qa/2) est une valeur correspondant à la moitié de la capacité de l'anode du dispositif électrochimique,
- N est un entier naturel supérieur ou égal à 1, et
- σ correspond à l'estimation de la largeur du pic,
- ε est un seuil de sécurité, choisi.

5. Procédé selon l'une des revendications précédentes, dans lequel si ladite combinaison est inférieure à la capacité du dispositif électrochimique, une dégradation du dispositif électrochimique, **caractérisée par** la formation d'un dépôt métallique à l'anode du dispositif électrochimique, est en outre prédite.

6. Procédé selon la revendication 5, dans lequel le dispositif électrochimique comporte au moins une batterie au lithium et le dépôt se formant à l'anode est un dépôt de lithium métallique.

7. Procédé selon l'une des revendications 5 et 6, dans lequel l'anode comporte du graphite.

8. Procédé selon l'une des revendications précédentes, comportant en outre la génération d'un signal d'alerte si ladite combinaison est inférieure à la capacité du dispositif électrochimique.

9. Procédé selon la revendication 8, dans lequel le signal d'alerte indique une fin de vie imminente du dispositif électrochimique.

10. Procédé selon l'une des revendications précédentes, dans lequel ladite prédiction d'accélération de la dégradation de la capacité du dispositif électrochimique est corroborée par une augmentation d'un volume mesuré du dispositif électrochimique, au-delà d'un seuil.

11. Dispositif de prédiction d'une accélération de dégradation de capacité d'un dispositif électrochimique, comportant au moins un circuit de traitement relié au dispositif électrochimique pour la mise en oeuvre du procédé selon l'une des revendications précédentes.

12. Programme informatique comportant des instructions pour la mise en oeuvre du procédé selon l'une des revendications 1 à 10, lorsque lesdites instructions sont exécutées par un processeur d'un circuit de traitement.

## Patentansprüche

1. Verfahren zur Vorhersage einer Beschleunigung der Kapazitätsverschlechterung einer elektrochemischen Vorrichtung, wobei das Verfahren umfasst:
- Gewinnung von Messdaten von Punkten einer Funktion, die eine Spannung (V) an den Anschlüssen der elektrochemischen Vorrichtung mit einem Ladezustand der elektrochemischen Vorrichtung (Q) verbindet, und einer Kapazitätsmessung (Qt) der elektrochemischen Vorrichtung,
- Berechnung der Ableitung der Funktion und Identifizierung eines Peaks der Variation der Ableitung, die auf einen Wendepunkt der Variation der Funktion zurückzuführen ist und eine Größe charakterisiert, die für eine Anodenkapazität der elektrochemischen Vorrichtung (Qa/2) repräsentativ ist,
- Schätzen einer Peakbreite (σ) und Vergleichen einer Kombination aus der Peakbreite und der für die Anodenkapazität repräsentativen Größe mit der Kapazitätsmessung (Qt) der elektrochemischen Vorrichtung, und
- falls die Kombination kleiner als die Kapazität der elektrochemischen Vorrichtung ist, Vorhersage einer Beschleunigung der Kapazitätsverschlechterung der elektrochemischen Vorrichtung.

2. Verfahren nach Anspruch 1, wobei die Funktion, deren Ableitung berechnet wird (dV/dQ), die Variation der Spannung (V) als Funktion des Ladezustands (Q) der elektrochemischen Vorrichtung ist, und wobei die für die Anodenkapazität repräsentative Größe die Hälfte der Anodenkapazität der elektrochemischen Vorrichtung (Qa/2) ist, die durch die Abszisse des Peaks gegeben ist.

3. Verfahren nach einem der vorhergehenden Ansprüche, wobei die Schätzung der Peakbreite (σ) durch Anpassung des Peaks durch eine Gaußsche Kurve und durch Messung der Breite der Gaußschen Kurve durchgeführt wird.

4. Verfahren nach einem der vorhergehenden Ansprüche, wobei die Kombination gegeben ist durch 2*(Qa/2) - N. σ - ε, wobei gilt:
- (Qa/2) ist ein Wert, der der Hälfte der Anodenkapazität der elektrochemischen Vorrichtung entspricht,
- N ist eine natürliche Zahl größer oder gleich 1, und
- σ entspricht der geschätzten Peakbreite,
- ε ist ein Sicherheitsschwellenwert, der gewählt wird.

5. Verfahren nach einem der vorhergehenden Ansprüche, wobei, wenn die Kombination kleiner als die Kapazität der elektrochemischen Vorrichtung ist, ferner eine Verschlechterung der elektrochemischen Vorrichtung vorhergesagt wird, die durch die Bildung einer Metallablagerung an der Anode der elektrochemischen Vorrichtung gekennzeichnet ist.

6. Verfahren nach Anspruch 5, wobei die elektrochemische Vorrichtung wenigstens eine Lithiumbatterie umfasst und die sich an der Anode bildende Ablagerung eine metallische Lithium-Ablagerung ist.

7. Verfahren nach einem der Ansprüche 5 oder 6, wobei die Anode Graphit umfasst.

8. Verfahren nach einem der vorhergehenden Ansprüche, welches ferner die Erzeugung eines Warnsignals umfasst, wenn die Kombination kleiner ist als die Kapazität der elektrochemischen Vorrichtung.

9. Verfahren nach Anspruch 8, wobei das Warnsignal ein bevorstehendes Lebensende der elektrochemischen Vorrichtung anzeigt.

10. Verfahren nach einem der vorhergehenden Ansprüche, wobei die Vorhersage einer Beschleunigung der Kapazitätsverschlechterung der elektrochemischen Vorrichtung durch einen Anstieg eines gemessenen Volumens der elektrochemischen Vorrichtung über einen Schwellenwert hinaus untermauert wird.

11. Vorrichtung zur Vorhersage einer Beschleunigung der Kapazitätsverschlechterung einer elektrochemischen Vorrichtung, umfassend wenigstens eine Verarbeitungsschaltung, die mit der elektrochemischen Vorrichtung verbunden ist, um das Verfahren nach einem der vorhergehenden Ansprüche durchzuführen.

12. Computerprogramm, umfassend Anweisungen zur Durchführung des Verfahrens nach einem der Ansprüche 1 bis 10, wenn die Anweisungen von einem Prozessor einer Verarbeitungsschaltung ausgeführt werden.

## Claims

1. Method for predicting an acceleration of the degradation in capacity of an electrochemical device, the method comprising:
- Obtaining point measurement data from a function linking a voltage (V) across the terminals of the electrochemical device to a state of charge of the electrochemical device (Q), and a measurement of the capacity (Qt) of the electrochemical device,
- Calculating the derivative of said function and identifying a peak in the variation of said derivative, due to an inflection in the variation of said function and characterizing a quantity representative of an anode capacity of the electrochemical device (Qa/2),
- Estimating a width of the peak (σ) and comparing a combination of the peak width and the quantity representative of the anode capacity, with the measurement of the capacity (Qt) of the electrochemical device, and
- If said combination is less than the capacity of the electrochemical device, predicting an acceleration of the degradation in capacity of the electrochemical device.

2. Method according to claim 1, wherein the function for which the derivative is calculated (dV/dQ) is the variation in voltage (V) as a function of the state of charge (Q) of the electrochemical device, and the quantity representative of the anode capacity is half the capacity of the anode of the electrochemical device (Qa/2), given by the abscissa of said peak.

3. Method according to one of the preceding claims, wherein the width of the peak (σ) is estimated by fitting a Gaussian to said peak and measuring the width of said Gaussian.

4. Method according to one of the preceding claims, wherein said combination is given by 2*(Qa/2) - N. σ - ε, where:
- (Qa/2) is a value corresponding to half the capacity of the anode of the electrochemical device,
- N is a natural number greater than or equal to 1, and
- σ corresponds to the estimate of the width of the peak,
- ε is a chosen safety threshold.

5. Methodaccording to one of the preceding claims, wherein, if said combination is less than the capacity of the electrochemical device, a degradation of the electrochemical device, **characterized by** formation of a metallic deposit at the anode of the electrochemical device, is further predicted.

6. Method according to claim 5, wherein the electrochemical device comprises at least one lithium battery and the deposit forming at the anode is a deposit of metallic lithium.

7. Method according to one of claims 5 and 6, wherein the anode comprises graphite.

8. Method according to one of the preceding claims, further comprising the generation of a warning signal if said combination is less than the capacity of the electrochemical device.

9. Method according to claim 8, wherein the warning signal indicates an imminent end of life of the electrochemical device.

10. Method according to one of the preceding claims, wherein said prediction of an acceleration of the degradation in capacity of the electrochemical device is corroborated by an increase of a measured volume of the electrochemical device, to beyond a threshold.

11. Device for predicting an acceleration of the degradation in capacity of an electrochemical device, comprising at least one processing circuit connected to the electrochemical device in order to implement the method according to one of the preceding claims.

12. Computer program comprising instructions for implementing the method according to one of claims 1 to 10, when said instructions are executed by a processor of a processing circuit.
